# EUROPÄISCHE PATENTANMELDUNG

(11) **EP 1 278 053 A1**
(43) Veröffentlichungstag der Anmeldung: **22.01.2003**
(21) Anmeldenummer: 02102021.9
(22) Anmeldetag: 11.07.2002
(51) Int. Cl.: G01L 9/00

(54) **Drucksensoranordnung und zugehöriges Herstellungsverfahren**

(30) Priorität: 17.07.2001 DE 10134847
(71) Anmelder: SIEMENS AKTIENGESELLSCHAFT, 80333 München (DE)
(72) Erfinder: Kober, Sven, 47800 Krefeld (DE); Rudolph, Tom, 47506 Neukirchen-Vluyn (DE)

(57) **Zusammenfassung**

Auf einer Drucksensoranordnung (52) mit einer Halbleiter-Trägerplatte (12), ist eine Membran (14) angeordnet. Die Halbleiter-Trägerplatte wird beispielsweise in Flip-Chip-Technik auf einem Schaltungsträger (50) angeordnet. Die Membran (14) ist dem Schaltungsträger (50) zugewandt und wird so durch den Schaltungsträger vor mechanischer Zerstörung geschützt.

## Beschreibung

Die Erfindung betrifft eine Drucksensoranordnung mit einer Trägerplatte, die bspw. aus einem Halbleitermaterial besteht, z.B. aus Silizium. Auf der einen Fläche der Trägerplatte ist eine Membran angeordnet, die an einen in der Trägerplatte ausgebildeten Hohlraum grenzt. Auf der Trägerplatte ist ein von dem Membran betätigtes elektronisches Erfassungsmittel angeordnet, z.B. ein piezoresistives Bauelement oder eine Elektrodenanordnung. Auf der Trägerplatte befinden sich außerdem elektrisch leitende Anschlussflächen, die mit dem Erfassungsmittel verbunden sind. Die Drucksensoranordnung enthält einen Schaltungsträger, der die Trägerplatte, eine Schaltungsanordnung und mit der Schaltungsanordnung elektrisch leitend verbundene Gegenanschlussflächen trägt. Außerdem enthält die Drucksensoranordnung elektrisch leitende Verbindungselemente zwischen den Anschlussflächen und den Gegenanschlussflächen.

Die Schaltungsanordnung ist beispielsweise eine Schaltung für eine andere Anwendung, mit der die Drucksensoranordnung kombiniert wird. So sind beispielsweise Schaltungsanordnungen für digitale Uhren, Fahrradcomputer oder Tauchcomputer bekannt, die mit einem Drucksensor kombiniert sind, so dass neben der Uhrzeit bzw. den Fahrkilometern auch die mit Hilfe des Umgebungsdrucks bestimmte Höhe abgelesen werden kann, in der sich der Träger der Schaltungsanordnung befindet.

Ein Beispiel für einen bekannten Drucksensor ist der Drucksensor MS5534AM des Herstellers Intersema Sensorik SA (Bevaix, Schweiz). Bei diesem Sensor ist eine piezoresistive Silizium-Membran in einer zylindrischen Hülse aus Edelstahl montiert. Die Hülse ist auf einen Keramikträger aufgeklebt. Der Keramikträger lässt sich auf dem Schaltungsträger beispielsweise mit Hilfe der SMD-Technik (Surface Mounted Device) anschließen. Eine für die Sensor-Signalaufbereitung und die Analog-Digital-Wandlung erforderliche Schaltung ist auf der Unterseite des Keramikträgers angeordnet. Von dem Erfassungsmittel führen Bonddrähte zum Keramikträger. Zum Schutz vor Feuchtigkeit und mechanischen Einflüssen ist die Membran in der Hülse mit Silikon vergossen.

Bekannte Sensoren haben vergleichsweise große Abmessungen, die im Zentimeterbereich liegen bzw. nahe an diesen Bereich heranreichen. So hat der Drucksensor MS5534AM eine Breite von 9 mm und eine Länge von 9 mm. Bekannte Drucksensoren sind aufgrund ihrer sperrigen Gehäuse für eine automatisierte SMD-Montage nur bedingt geeignet.

Es ist Aufgabe der Erfindung, eine Drucksensoranordnung anzugeben, die wenig Bauraum beansprucht und die außerdem einfach mittels eines automatischen Verfahrens auf dem Schaltungsträger montiert werden kann. Außerdem soll ein zugehöriges Herstellungsverfahren für die Drucksensoranordnung angegeben werden.

Die auf die Drucksensoranordnung bezogene Aufgabe wird durch eine Drucksensoranordnung mit den im Patentanspruch 1 angegebenen Merkmalen gelöst. Weiterbildungen sind in den Unteransprüchen angegeben.

Die Erfindung geht von der Überlegung aus, dass die Membran sehr dünn sein muss, um auch kleine Schwankungen des Umgebungsdruckes zu registrieren. Eine solche dünne Membran muss vor mechanischen Umwelteinflüssen geschützt werden, da sie sehr empfindlich ist. Darum wurde bisher die Membran immer mit einem zusätzlichen Gehäuse geschützt. Der Einsatz der sogenannten Nacktchiptechnik (Chip on Board), bei dem eine gehäuselose Halbleiter-Trägerplatte direkt auf den Schaltungsträger montiert wird, wurde nicht in Betracht gezogen. Jedoch lässt sich ein wirksamer Schutz der empfindlichen Membran auch dadurch gewährleisten, dass der die Halbleiter-Trägerplatte tragende Schaltungsträger für diesen Zweck genutzt wird.

Bei der erfindungsgemäßen Drucksensoranordnung liegt die Membran zwischen dem Hohlraum und dem Schaltungsträger. Das bedeutet, dass diejenige Seite der Trägerplatte bzw. des Chips, welche die Membran trägt, der Schaltungsanordnung zugewandt ist. Der Schaltungsträger schützt die Membran wirksam vor mechanischen Einflüssen. Ein zusätzliches Gehäuse, das im wesentlichen nur die Aufgabe hat, die Membran zu schützen, ist nicht mehr erforderlich. Damit entsteht eine einfach aufgebaute und damit kostengünstig herzustellende Drucksensoranordnung.

Außerdem wird bei der erfindungsgemäßen Drucksensoranordnung der Abstand zwischen der Trägerplatte und dem Schaltungsträger durch die Abmessungen der elektrisch leitenden Verbindungselemente festgelegt, wie es für eine Nacktchipmontage kennzeichnend ist. Vorzugsweise ist die Spaltbreite des Spalts zwischen Trägerplatte und Schaltungsträger gleich einer Abmessung der Verbindungselemente entlang einer Richtung die parallel zu der Richtung liegt, in welcher die Spaltbreite festgelegt wird. Im Vergleich zu der Abmessung der Verbindungselemente dünne Schichten oder Kontaktbereiche zwischen einem Verbindungselement und der Trägerplatte bzw. dem Schaltungsträger führen zu Spaltbreiten, die den Abmessungen der Verbindungselemente annähernd gleich sind. Beispielsweise haben die Schichten oder Kontaktbereiche nur eine Schichtdicke, die kleiner als ein Zehntel oder kleiner als ein Hundertstel der Spaltbreite ist. Eine Montage der Trägerplatte mit Hilfe der SMD-Technik wird außerdem deshalb erleichtert, weil diejenige Fläche, an der die Membran nicht angebracht ist, sehr eben ist und mit Hilfe einer Vakuumpipette zur Montage angesaugt werden kann. Dies ist nicht der Fall, wenn Schaltungsträger, Membran und Hohlraum in einer anderen Reihenfolge angeordnet werden.

Bei einer Weiterbildung des erfindungsgemäßen Verfahrens liegt zwischen der Trägerplatte und dem Schaltungsträger ein Spalt mit einer Spaltbreite, die kleiner als 1 mm ist, vorzugsweise kleiner als 300 µm. Eine derartig kleine Spaltebreite gewährleistet einerseits , dass die Drucksensoranordnung nur eine geringe Bauhöhe beansprucht. Andererseits reicht eine Spaltbreite von wenigen Zehntel Mikrometern aus, um einen Druckausgleich zwischen der Umgebungsluft und der Luft im Spalt zu gewährleisten. Auch wird durch eine kleine Spaltbreite ein Eindringen von dünnen Gegenständen, welche die Membran zerstören könnten, in den Spalt verhindert

Bei einer nächsten Weiterbildung der erfindungsgemäßen Drucksensoranordnung sind miteinander verbundene Anschlussflächen und Gegenanschlussflächen jeweils einander zugewandt. Die Trägerplatte ist mit der Membran zum Schaltungsträger an dem Schaltungsträgerbefestigt. Die Verbindungselemente lassen sich so sehr kurz ausbilden.

Bei einer Weiterbildung der Drucksensoranordnung liegen eine die Membran enthaltende Fläche der Trägerplatte und eine der Membran benachbarte Fläche des Schaltungsträgers parallel zueinander. Diese Flächen sind dabei vorzugsweise die Flächen mit dem jeweils größten Flächeninhalt im Vergleich zu den Flächen der Trägerplatte bzw. des Schaltungsträgers. Durch diese Anordnung ergibt sich eine gleichmäßige Spaltbreite, die zu einer geringen Bauhöhe führt. Außerdem lassen sich gleichartig aufgebaute Verbindungselemente einsetzen.

Bei einer nächsten Weiterbildung der erfindungsgemäßen Drucksensoranordnung sind die Verbindungselemente Lötverbindungen oder elektrisch leitende Klebeverbindungen, die jeweils zwischen einer Anschlussfläche und einer Gegenanschlussfläche liegen. Bei einer alternativen Weiterbildung enthalten die Verbindungselemente starre elektrisch leitende Stege, deren Enden jeweils an einer Anschlussfläche und einer Gegenanschlussfläche befestigt sind, beispielsweise durch eine elektrische Lötverbindung oder durch eine elektrische Klebverbindung. Die bei den Weiterbildungen eingesetzten Verbindungstechniken sind auch als Plättchen-Schnellmontage-Technik (Flip-Chip-Technik) bzw. als Stege-Technik (Beam-Lead-Technik) bekannt, siehe z.B. das Buch "HalbleiterTechnologie", I. Ruge und H. Mader, Springer-Verlag, 1991, 3. Auflage, Abschnitte 9.4.1 bzw. 9.4.2, Seite 251 bis Seite 254.

Obwohl die beiden Techniken dort für die Montage von Chips in ein Chipgehäuse erläutert sind, lassen sie sich unverändert auch für die Montage eines Chips direkt auf eine Leiterplatte bzw. einen Schaltungsträger einsetzen. Bei der Plättchen-Schnellmontage-Technik (Flip-Chip) sind Kontaktflächen am Rand des Plättchens erhöht ausgebildet. Bei der Montage mit Löttechnik werden kugelförmig erhöhte Kontaktflächen eingesetzt. Die Kugeln bestehen entweder vollständig aus Lötmaterial oder enthalten zusätzlich einen Kern aus einem temperaturstabileren Material als das Lotmaterial.

Bei der Stege-Technik (Beam-Lead) werden ausgehend von Anschlussflächen, die am Rand des Chips liegen, starre Stege ausgebildet. Die Stege ragen über den Rand des Chips hinaus, beispielsweise um ca. 100 µm. Der Chip bzw. die Trägerplatte wird mit diesen Stegen auf dem Schaltungsträger montiert.

Bei einer anderen Weiterbildung des erfindungsgemäßen Verfahrens hat der Schaltungsträger in dem der Membran gegenüberliegenden Bereich eine Aussparung, z.B. ein Durchgangsloch, das den Schaltungsträger vollständig durchdringt. Das Loch dient zur besseren Belüftung der Membran auch bei einer sehr kleinen Spaltbreite zwischen der Trägerplatte und dem Schaltungsträger. Es werden auch andere Aussparungen eingesetzt, z.B. Aussparungen, die den Schaltungsträger nicht vollständig durchdringen und ggf. seitliche Kanäle zum Druckausgleich bilden. Die Kanäle lassen sich z.B. ausbilden:
- direkt im Schaltungsträger bspw. durch Ausfräsungen,
- in einer auf dem Schaltungsträger aufgetragenen Lotpaste oder Lotstoppaste bspw. durch Weglassen der Paste im Bereich der Kanäle, oder
- in einem Klebstoff mit elektrischen Eigenschaften, die von der Verdichtung des Klebstoffes abhängen, durch Weglassen des Klebstoffes im Bereich der Kanäle.

Bei einer nächsten Weiterbildung liegt eine durch den zu erfassenden Druck leicht verformbare Schutzschicht zwischen der Membran und dem Schaltungsträger. Durch die Schutzschicht wird die Membran bzw. auch die elektrisch aktive Seite der Trägerplatte wirksam vor Umwelteinflüssen, z.B. Feuchtigkeit, geschützt. Als Material der Schutzschicht wird beispielsweise Silikon eingesetzt. Enthält der Schaltungsträger ein Durchgangsloch zur Belüftung der Membran, so wird bei einer Ausgestaltung der Spalt zwischen Trägerplatte und Schaltungsträger vollständig durch die Schutzschicht ausgefüllt, beispielsweise durch Ausschäumen. Dies verhindert, dass in den Spalt eindringende Feuchtigkeit zu Schäden an der Trägerplatte oder an dem Schaltungsträger führt. Die Schutzmasse bildet bei einer Alternative eine Schutzwand, die einen Zwischenraum zwischen Membran und Schaltungsträger abdichtet, z.B. als Versiegelung entlang der Kanten der Trägerplatte.

Bei einer nächsten Weiterbildung der erfindungsgemäßen Drucksensoranordnung enthält das auf der Trägerplatte angeordnete Erfassungsmittel elektronische Bauelemente, die auf der Trägerplatte integriert sind. Diese Bauelemente dienen der Übertragung und/oder Verstärkung von Sensorsignalen des Drucksensors. Beispielsweise enthält das Erfassungsmittel eine Hilfskreis, der eine Hilfsenergie liefert, mit deren Hilfe sich dann der Druck erfassen lässt.

Bei einer Weiterbildung der erfindungsgemäßen Drucksensoranordnung ist der Schaltungsträger eine flexible Leiterfolie oder eine Leiterplatte. Die Leiterfolie bzw. die Leiterplatte enthält jeweils mindestens eine Leiterschicht und mindestens eine Isolierschicht. Beispielsweise wird als Material für die Leiterplatte das Material FR4 eingesetzt.

Die Erfindung betrifft außerdem ein Herstellungsverfahren, mit dem die erfindungsgemäße Drucksensoranordnung oder eine der Weiterbildungen hergestellt wird. Somit gelten die oben angegebenen technischen Wirkungen auch für das Herstellungsverfahren.

Im Folgenden werden Ausführungsbeispiele der Erfindung an Hand der beiliegenden Zeichnungen erläutert. Darin zeigen:
- Figur 1: eine Ansicht eines Halbleiter-Drucksensors von unten, und
- Figur 2: eine Schnittdarstellung durch den auf einer Leiterplatte montierten Halbleiter-Drucksensor.

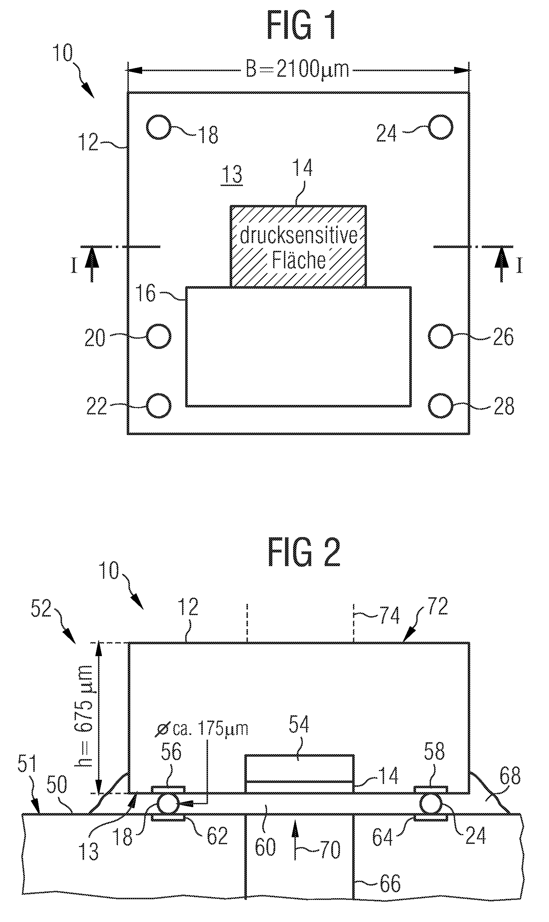

Figur 1 zeigt eine Unteransicht eines Halbleiter-Drucksensors 10. Der Halbleiter-Drucksensor 10 ist auf einem Silizium-Chip 12 angeordnet, der eine quadratische Grundfläche 13 mit einer Breite B von 2,1 mm hat. Im zentralen Bereich der Grundfläche 13 befindet sich als eine drucksensitive Fläche eine dünne Membran 14, die beispielsweise eine Dicke von 1 µm hat. An die Membran 14 grenzt auf der Grundfläche 13 ein Schaltungsbereich 16 an, in welchem Bauelemente eines Erfassungsmittels integriert worden sind, die Bestandteil des Drucksensors sind. Im linken Randbereich der Grundfläche 13 sind Kontaktkugeln 18 bis 22 aufgebracht. Im rechten Randbereich der Grundfläche 13 befinden sich ebenfalls drei Kontaktkugeln 24 bis 28. Zwischen den Kontaktkugeln 18 bis 28 und dem Schaltungsbereich 16 verlaufen nicht dargestellte Anschlussleitungen. Die Kontaktkugeln 18 bis 28 dienen zum Anschluss des Halbleiter-Drucksensors an eine Anwenderschaltung. So werden über die Kontaktkugeln 18 bis 28 eine Spannung angelegt und Steuersignale zu dem Schaltungsbereich 16 übertragen bzw. Signale von dem Schaltungsbereich 16 empfangen.

Der Aufbau der im Schaltungsbereich 16 integrierten Schaltung hängt von dem verwendeten Druckerfassungsprinzip und von den Anforderungen an die Erfassungsgenauigkeit des Drucksensors ab. Bei einem ersten Ausführungsbeispiel wird ein kapazitives Druckerfassungsprinzip eingesetzt. Die Membran 14 bildet zusammen mit dem Substrat des Chips 12 einen Plattenkondensator mit druckveränderlicher Kapazität. Mit Hilfe einer im Schaltungsbereich 16 integrierten Stromquelle wird dieser Kondensator periodisch aufgeladen und wieder entladen. Im Schaltungsbereich 16 ist außerdem eine binäre Zählereinheit integriert, die mit jeder Periode des Oszillators um den Wert 1 erhöht wird. Ein außerhalb des Drucksensors 10 liegender Prozessor der Anwenderschaltung veranlasst über ein Steuersignal den Beginn des Erfassungsvorgangs und setzt damit die Zählereinheit auf den Wert Null. Nach Ablauf eines vom Prozessor festgelegten Erfassungsintervalls tM wird der Zählvorgang gestoppt und das Zählergebnis kann von dem Prozessor über eine im Schaltungsbereich 16 enthaltene serielle Schnittstelle ausgelesen werden. Bei einer Ausgestaltung ist im Schaltungsbereich auch ein EEPROM-Baustein integriert (Electrical Erasable Programmable Read Only Memory), der zur Speicherung von Kalibrierdaten dient und ebenfalls seriell beschrieben oder gelesen werden kann. Aufgrund der Kalibrierung ist eine genaue Messung des Drucks in einer gesetzlich vorgeschriebenen Einheit möglich, z.B. des Luftdrucks oder eines Wasserdrucks.

Bei einem anderen Ausführungsbeispiel wird ein piezoresistives Druckerfassungsprinzip genutzt. Im Bereich der Membran sind piezoresistive Elemente angeordnet, in denen sich die Ladungsträgerbeweglichkeit und damit der ohmsche Widerstand abhängig vom Umgebungsdruck bzw. abhängig von der Durchbiegung der Membran ändert. Das Erfassungsmittel wertet die Größe des Widerstandes aus und erzeugt ein Sensorsignal.

Figur 2 zeigt eine Schnittdarstellung durch den auf eine Leiterplatte 50 montierten Drucksensor 10 entlang einer in Figur 1 gezeigten Schnittfläche I, die in einem Winkel von 90 Grad zur Zeichenebene liegt. Der Drucksensor 10, die Leiterplatte 50 und die Kontaktkugeln 18 bis 28 bilden eine Drucksensoranordnung 52.

In Figur 2 ist außerdem die Höhe h des Halbleiter-Drucksensors 10 dargestellt. Diese Höhe h wird durch die Höhe einer Siliziumscheibe (Wafer) bestimmt, auf der der Chip 12 gemeinsam mit anderen gleichartig aufgebauten Chips gefertigt worden ist. Im Ausführungsbeispiel beträgt die Höhe h gleich 675 µm. Die Kontaktkugeln 18 bis 28 haben einen Durchmesser von etwa 175 µm.

Wie in Figur 2 gezeigt, grenzt die Membran 14 an einen geschlossenen Hohlraum 54, der im Inneren des Chips 12 ausgebildet ist. Der Hohlraum 54, die Membran 14 und die Leiterplatte 50 liegen in dieser Reihenfolge auf einer Linie.

In Figur 2 sind außerdem Leiterbahnen 56 und 58 dargestellt, die von der Kontaktkugel 18 auf dem Chip 12 zum Schaltungsbereich 16 führen.

Die Leiterplatte 50 ist eine beidseitig mit Leiterbahnen bedruckte Leiterplatte aus Standard-FR4-Material. Die Bestückungsseite der Leiterplatte 50 liegt auf der in Figur 2 dargestellten Seite 51, auf der auch der Halbleiter-Drucksensor 10 angeordnet ist. Zwischen dem Halbleiter-Drucksensor 10 und der Leiterplatte 50 liegt ein Spalt 60, dessen Spaltbreite durch den Durchmesser der Kontaktkugeln 18 bis 28 bestimmt wird und mit dem Durchmesser der Kontaktkugeln 18 bis 28 übereinstimmt. Auf der Seite 51 der Leiterplatte 50 sind die Kontaktkugeln 18 bzw. 24 mit Gegenanschlussflächen 62 bzw. 64 verbunden, die an Anschlussflächen der Leiterbahnen 56 und 58 zum Anschluss der Kontaktkugeln 18 bzw. 24 ausgerichtet sind. Die Anschlussflächen der Leiterbahnen 56 und 58 haben zueinander die gleiche Lage, welche die Gegenanschlussflächen 62, 64 zueinander haben.

Der Drucksensor 10 wurde mit Hilfe der Plättchen-Schnellmontage-Technik (Flip-Chip-Technik) auf der Leiterplatte 50 montiert. Dazu wurden zunächst die Kontaktkugeln 18 bis 28 auf den für sie vorgesehenen Anschlussflächen der Leiterbahnen 56 bis 58 aufgebracht. Anschließend wurden die Chips durch Sägen des Wafers vereinzelt. Der vereinzelte Chip 12 wurde mit Hilfe einer Vakuumpipette 74 an der für ihn vorgesehene Stelle auf der Leiterplatte 50 platziert. Beispielsweise wurde auf die Leiterplatte 50 zuvor eine Lotpaste in einem Siebdruckprozess aufgerakelt. Beim Plazieren werden die Kontaktkugeln 18 bis 28 in die Lotpaste eingedrückt. In einem folgenden Reflowprozess wurden die Lotpaste und Randbereiche der Kontaktkugeln 18 bis 28 erneut verflüssigt, so dass sich Lötverbindungen zwischen den Kontaktkugeln 18 bis 28 und den Anschlussflächen 62, 64 auf der Leiterplatte 50 bildeten.

Die Leiterplatte 50 enthält in einem der Membran 14 gegenüberliegenden Bereich ein Durchgangsloch 66, z.B. eine Durchgangsbohrung. Das Durchgangsloch 66 dient zur Zufuhr von Umgebungsluft zur Membran 14.

Bei einem nächsten Ausführungsbeispiel wird der Spalt 60 mit einer Silikonmasse 68 ausgeschäumt, wobei das Durchgangsloch frei von Silikonmasse 68 bleibt. Die sich im Durchgangsloch 66 befindende Umgebungsluft drückt auf die Silikonmasse 68, die sich infolge des Druckes durchbiegt und ihrerseits auf die Membran 14 drückt, siehe Pfeil 70.

Der in den Figuren 1 und 2 dargestellte Drucksensor nimmt eine Bauraum von etwa 2,1 mm (Millimeter) mal 2,1 mm mal 0,85 mm, d.h. von 3,8 mm³ ein. Im Gegensatz dazu hat der in der Einleitung erwähnte Sensor MS5534AM ein Bauvolumen von 9 mm mal 9 mm mal 5,2 mm, d.h. von 236 mm³. Durch die Erfindung wird also eine Reduzierung des Nettovolumens auf etwa 1/60 erreicht. Durch diese Volumenreduzierung lassen sich neue Anwendungsgebiete für Drucksensoren erschließen.

Außerdem hat der Chip 12 eine ebene und im Vergleich zur Membran mechanische robuste Oberfläche 72, an der eine Pipette 74 den Drucksensor 10 zur Montage ansaugen kann. Die Montage im Rahmen der SMD-Technik lässt sich so sehr sicher und sehr einfach durchführen.

Der Chip 12 wurde im Ausführungsbeispiel in CMOS-Technologie (Complementary Metalloxid Semiconductor) gefertigt. Diese Technologie zeichnet sich durch einen geringen Leistungsverbrauch aus, der es ermöglicht, auf ein Gehäuse für den Chip 12 vollständig zu verzichten. Jedoch lassen sich auch andere Halbleiter-Technologien zur Herstellung des Chips 12 einsetzen.

Zur Herstellung der Membran 124 wurde ein spezieller oberflächen-mikromechanischer Ätzprozess eingesetzt. Zum Ätzen genutzte Öffnungen im Chip 12 wurden nach dem Ätzen wieder verschlossen.

## Patentansprüche

1. Drucksensoranordnung (52),
mit einer Trägerplatte (12), die eine Membran (14)enthält, die an einen in der Trägerplatte (12) ausgebildeten Hohlraum (54) grenzt,
mit einem von der Membran (14) betätigten und elektronisch arbeitenden Erfassungsmittel (16), das auf der Trägerplatte (12) angeordnet ist,
mit auf der Trägerplatte (12) angeordneten elektrisch leitenden Anschlussflächen (56, 58), die mit dem Erfassungsmittel (16) verbunden sind,
mit einem Schaltungsträger (50), der die Trägerplatte (12), eine Schaltungsanordnung und mit der Schaltungsanordnung elektrisch leitend verbundene Gegenanschlussflächen (62, 64) trägt,
und mit elektrisch leitenden Verbindungselementen (18 bis 28) zwischen den Anschlussflächen (56, 58) und den Gegenanschlussflächen (62, 64),
**dadurch gekennzeichnet, dass** der Abstand zwischen der Trägerplatte (12) und dem Schaltungsträger (50) durch die Abmessungen der elektrisch leitenden Verbindungselemente (18 bis 28) festgelegt wird,
und dass die Membran (14) zwischen dem Hohlraum (54) und dem Schaltungsträger (50) liegt.

2. Drucksensoranordnung (52) nach Anspruch 1, **dadurch gekennzeichnet, dass** zwischen der Trägerplatte (12) und dem Schaltungsträger (50) ein Spalt (60) mit einer Spaltbreite liegt, die kleiner als 1 mm ist.

3. Drucksensoranordnung (52) nach einem der vorhergehenden Ansprüche, **dadurch gekennzeichnet, dass** miteinander verbundene Anschlussflächen (56, 62) und Gegenanschlussflächen (58, 64) jeweils einander zugewandt sind.

4. Drucksensoranordnung (52) nach einem der vorhergehenden Ansprüche, **dadurch gekennzeichnet, dass** eine die Membran (14) enthaltende Fläche (13) der Trägerplatte (12) und die der Membran (14) benachbarte Fläche (51) des Schaltungsträgers (50) parallel zueinander liegen.

5. Drucksensoranordnung (52) nach einem der vorhergehenden Ansprüche, **dadurch gekennzeichnet, dass** die Verbindungselemente (18 bis 28) Lötverbindungen oder elektrisch leitende Klebverbindungen zwischen jeweils einer Anschlussfläche (56, 58) und einer Gegenanschlussfläche (62, 64) sind,
oder dass die Verbindungselemente starre elektrisch leitende Stege sind, deren Enden jeweils an einer Anschlussfläche (56, 58) und an einer Gegenanschlussfläche (62, 64) befestigt sind.

6. Drucksensoranordnung (52) nach einem der vorhergehenden Ansprüche, **dadurch gekennzeichnet, dass** der Schaltungsträger (50) und/ oder die Trägerplatte (12) eine Aussparung hat, die zu der Membran (14) führt.

7. Drucksensoranordnung (52) nach einem der vorhergehenden Ansprüche, **dadurch gekennzeichnet, dass** eine durch Umgebungsdruck leicht verformbare Schutzmasse als Schutzschicht (68) zwischen Membran (14) und Schaltungsträger (50) liegt oder als Schutzwand einen Zwischenraum zwischen Membran (14) und Schaltungsträger (50) abdichtet,
und/oder dass die Schutzschicht (68) den Raum (60) zwischen Trägerplatte (12) und Schaltungsträger (50) vollständig ausfüllt.

8. Drucksensoranordnung (52) nach einem der vorhergehenden Ansprüche, **dadurch gekennzeichnet, dass** das Erfassungsmittel (16) elektronische Bauelemente enthält, die auf der Trägerplatte (12) integriert sind.

9. Drucksensoranordnung (52) nach einem der vorhergehenden Ansprüche, **dadurch gekennzeichnet, dass** der Schaltungsträger (50) eine flexible Leiterfolie oder eine Leiterplatte ist, die mindestens eine Leiterschicht und mindestens eine Isolierschicht enthält.

10. Drucksensoranordnung (52) nach einem der vorhergehenden Ansprüche, **dadurch gekennzeichnet, dass** die Anschlussflächen (56, 58) auf der die Membran (14) enthaltenden Fläche (13) der Trägerplatte (12) angeordnet sind.

11. Herstellungsverfahren für eine Drucksensoranordnung (52),
bei dem eine Trägerplatte (12) gefertigt wird, die eine Membran (14)enthält,
bei dem die Trägerplatte (12) mit elektrisch leitenden Verbindungselementen (18 bis 28) versehen wird,
bei dem die Trägerplatte (12) an einen Schaltungsträger (50) in einem durch die Verbindungselemente festgelegten Abstand angeordnet wird, wobei diejenige Seite der Trägerplatte, welche die Membran trägt, dem Schaltungsträger (50) zugewandt ist,
und bei dem die Verbindungselemente (18 bis 28) anschließend mit elektrisch leitenden Anschlussflächen (62, 64) elektrisch leitend verbunden werden, die auf dem Schaltungsträger (50) an den Enden der Verbindungselemente (18 bis 28) angeordnet sind.

12. Herstellungsverfahren nach Anspruch 11, **dadurch gekennzeichnet, dass** beim Herstellungsverfahren Verfahrensschritte ausgeführt werden, die zum Herstellen einer Drucksensoranordnung (52) nach einem der Ansprüche 1 bis 10 erforderlich sind.
